# EUROPEAN PATENT APPLICATION

(11) **EP 3 872 400 A1**
(43) Date of publication of application: **01.09.2021**
(21) Application number: 20206727.8
(22) Date of filing: 10.11.2020
(51) Int. Cl.: F21V 9/30, F21V 9/38, H01L 25/075, H01L 33/50, F21Y 105/16, F21Y 113/13, F21Y 115/10

(54) **WAVELENGTH CONVERSION FILM AND LIGHTING DEVICE USING THE SAME**

(30) Priority: 27.02.2020 KR 20200023980
(71) Applicant: Sherpa Space Inc., Daejeon 34051 (KR)
(72) Inventor: YUN, Choa Mun, 34051 Daejeon (KR); KANG, Sageun, 34051 Daejeon (KR); CHOI, Wonjoon, 34051 Daejeon (KR)
(74) Representative: Schmitt-Nilson Schraud Waibel Wohlfrom Patentanwälte Partnerschaft mbB

(57) **Abstract**

The present disclosure relates to a wavelength conversion film and a lighting device using the same. More specifically, it relates to a wavelength conversion film and a lighting device using the same, in which a wavelength conversion region is arranged opposite to a first light source, and a transmission region is arranged opposite a the second light source, thereby converting and outputting wavelength of a selected specific light.

According to an embodiment of the present disclosure, a lighting device includes: a lighting unit in which a first light source in a first wavelength band and a second light source in a second wavelength band are arranged; and a wavelength conversion film in which a wavelength conversion region is arranged at a position opposite to the first light source, and a transmission region is arranged at a position opposite to the second light source.

In addition, according to a wavelength conversion film of the embodiment of the present disclosure, a wavelength conversion region is arranged at a position opposite to a first light source in a first wavelength band of a lighting unit, and a transmission region is arranged at a position opposite to a second light source in a second wavelength band of the lighting unit.

## Description

### CROSS-REFERENCE TO RELATED APPLICATION

This application claims priority from Korean Patent Application No. 10-2020-0023980 filed on February 27, 2020 in the Korean Intellectual Property Office, and all the benefits accruing therefrom under 35 U.S.C. 119, the contents of which in their entirety are herein incorporated by reference.

### BACKGROUND

### 1. Technical Field

The present disclosure relates to a wavelength conversion film and a lighting device using the same. More specifically, it relates to a wavelength conversion film and a lighting device using the same, in which a wavelength conversion region is arranged opposite to a first light source, and a transmission region is arranged opposite a second light source, thereby converting and outputting wavelength of a selected specific light.

### 2. Description of the Related Art

In general, when the land area is small and the population is large, large-scale mechanization is impossible due to the limited cultivation area. Accordingly, the food problem has been solved by chemical farming methods that use large amounts of fertilizers and pesticides. However, this has a limit in productivity. In addition, food production is unstable in polar regions where sunlight is insufficient or desert regions where water is insufficient. Accordingly, facility agriculture has emerged, which improves quality by appropriately controlling the environment inside the limited space while increasing the production volume by expanding the production space and extending the production period. Here, in order to improve productivity in facility agriculture, it is important to maximize genetic traits of crops by artificially controlling environmental conditions inside the facility, which is a limited space. As an example, research results have been published showing that the growth efficiency may be improved by artificially changing the light irradiation environment inside the facility.

Plants receive light from chlorophyll and proceed to photosynthesis. The photosynthesis begins with the production of chemical energy so that the chlorophyll molecules in plants capture light energy and convert water and carbon dioxide into carbohydrates, the basic nutrients of life. Here, the chlorophyll is characterized by its ability to absorb light differently depending on the wavelength of light. In other words, the chlorophyll mainly absorbs light in the blue and red wavelength bands, and reflects most of the light in green and yellow wavelength bands, which are not very important during the photosynthesis. Plants do not evenly use the entire white light from the sun, but selectively use only light in a specific wavelength band. Therefore, when growing crops with artificial light, irradiating white light wastes energy unnecessarily. It is efficient to irradiate blue or red light inside the facility depending on the situation.

However, the wavelengths of blue and red do not have the same effect on all plants. The required wavelength of light varies according to the type of crop and growth state or growth stage. Therefore, a technology may be required to irradiate artificial light in the facility with an optimal wavelength depending on the situation.

According to this request, Korean Patent No. 10-1568707 (Patent Document 001) discloses a white LED device including a light-emitting polymer film containing silica particles including quantum dots and a method of manufacturing the same.

According to Patent Document 001, the white LED device includes: a blue LED chip; a phosphor plate arranged on the LED chip; and a light-emitting polymer film containing silica particles including quantum dots stacked on the phosphor plate. However, chlorophyll mainly absorbs light in blue and red wavelength bands, and reflects most of the light in green and yellow wavelength bands, which are not very important during photosynthesis. Therefore, Patent Document 001 is not suitable for plant growth.

In addition, Korean Patent No. 10-1502960 (Patent Document 002) discloses an LED lighting module that optimizes the efficiency of early plant growth and an LED lighting device equipped with it.

According to Patent Document 002, RGY phosphor and RGY selected phosphor are applied to a separate LED blue chip light source, in which the RGY phosphor is a combination of red, green and yellow series that allows effective light energy irradiation during the overall growth period of plants, and the RGY selected phosphor is a combination of phosphors of at least one or more of yellow, green, and red series that irradiate light energy important for the initial growth of plants. However, in the method of converting the wavelength by applying it to the LED chip, it is difficult to dissipate heat generated by the LED chip. Moreover, due to the heat generated by the LED chip, a core portion of quantum dots reacts with water or oxygen to be oxidized. In addition, the luminous efficiency is lowered by oxidation.

### 3. Prior Art Document

### [Patent Document]

(Patent Document 1) Korean Patent No. 10-1568707 (November 6, 2015)
(Patent Document 2) Korean Patent No. 10-1502960 (March 10, 2015)

### SUMMARY

The present disclosure has been derived to solve the problems of the prior art as described above. The object of the embodiments of the present disclosure is to provide a wavelength conversion film and a lighting device using the same, in which some light of a lighting unit is transmitted through a wavelength conversion region, and the remaining light is transmitted through a transmission region.

The other object of the embodiments of the present disclosure is to provide a wavelength conversion film and a lighting device using the same, in which wavelength of light may be converted without applying an encapsulant to an LED chip.

Another object of the embodiments of the present disclosure is to provide a wavelength conversion film that may be applied to an already manufactured lighting unit to convert wavelength of light without replacing a lighting device.

Another object of the embodiments of the present disclosure is to provide a wavelength conversion film and a lighting device using the same, in which the wavelength conversion film and the lighting device using the same according to the present disclosure may be applied to plant growth to provide an environment suitable for plant growth, thereby providing optimal light required for plant growth.

According to an embodiment of the present disclosure, a lighting device includes: a lighting unit in which a first light source in a first wavelength band and a second light source in a second wavelength band are arranged; and a wavelength conversion film in which a wavelength conversion region is arranged at a position opposite to the first light source, and a transmission region is arranged at a position opposite to the second light source.

In addition, according to another embodiment of the present disclosure, a lighting device includes: a lighting unit in which a first light source in a first wavelength band and a second light source in a second wavelength band are arranged; and a wavelength conversion film in which a first wavelength conversion region is arranged at a position opposite to the first light source, and a second wavelength conversion region is arranged at a position opposite to the second light source.

In addition, according to a wavelength conversion film of the embodiment of the present disclosure, a wavelength conversion region is arranged at a position opposite to a first light source in a first wavelength band of a lighting unit, and a transmission region is arranged at a position opposite to a second light source in a second wavelength band of the lighting unit.

In addition, according to a wavelength conversion film of another embodiment of the present disclosure, a first wavelength conversion region is arranged in a region opposite to a first light source in a first wavelength band of a lighting unit, and a second wavelength conversion region is arranged in a region opposite to a second light source in a second wavelength band of the lighting unit.

Particular embodiments of the invention may include any of the following features, alone or in combination.

Here, the first light source is a first color, and the second light source is formed of a second color different from the first color.

The first light source and the second light source may be repeatedly arranged in a predetermined pattern.

The wavelength conversion region may include any one wavelength conversion material of inorganic phosphors, quantum dots, perovskites, and cellophanes.

The wavelength conversion region may include a mixed layer of at least two of inorganic phosphors, quantum dots, perovskites, and light scattering agents.

At least two of an inorganic phosphor layer, a quantum dot layer, and a perovskite layer may be stacked in the wavelength conversion region.

An air gap may be formed between the wavelength conversion materials in the wavelength conversion region.

A first nano patterned layer for scattering emitted light or a second nano patterned layer for inducing emitted light in a preset direction may be formed on a surface of the wavelength conversion film.

According to the embodiments of the present disclosure, in a lighting unit in which light sources of different wavelength bands are mixed, wavelength of a light emitted from a specific light source may be converted and irradiated. Therefore, the selection of the emitted light wavelength is expanded.

In addition, by simply attaching a wavelength conversion film of the embodiments of the present disclosure to the already prepared lighting unit, the wavelength of light may be converted and irradiated. Therefore, it is easy to convert the wavelength required for plant growth.

Also, even if a blue light source that is relatively inexpensive than a red light source is configured, a blue light source may be converted into a light source having red and green wavelengths for irradiation. Therefore, it is possible to lower the manufacturing cost of a lighting device.

Moreover, when applying a wavelength conversion filter and a lighting device using the same according to the embodiments of the present disclosure to plant growth, a light source suitable for plant growth may be provided so that plants may be grown early. Therefore, it is possible to increase production efficiency while shortening a growth cycle of plant growth.

### BRIEF DESCRIPTION OF THE DRAWINGS

The above and other aspects and features of the embodiments of the present disclosure will become more apparent by describing in detail exemplary embodiments thereof with reference to the attached drawings, in which:
FIGS. 1A and 1B are conceptual views for explaining the principle of an quantum dot, respectively;
FIG. 1C is a view showing a luminescence principle of a phosphor;
FIG. 2 is a schematic exploded perspective view of a lighting device according to an embodiment of the present disclosure;
FIG. 3 is a cross-sectional view of a wavelength conversion film of an embodiment applied to the lighting device according to the present disclosure;
FIG. 4 is a schematic exploded perspective view of a lighting device according to another embodiment of the present disclosure;
FIG. 5 is a schematic exploded perspective view of a lighting device according to another embodiment of the present disclosure;
FIG. 6 is a schematic exploded perspective view of a lighting device according to another embodiment of the present disclosure;
FIGS. 7 and 8 are schematic cross-sectional views of a lighting device to which a wavelength conversion film according to an embodiment of the present disclosure is applied, respectively;
FIGS. 9 and 10 are schematic cross-sectional and plan views, respectively, of a lighting device to which a wavelength conversion film according to another embodiment of the present disclosure is applied;
FIG. 11 is a view showing a light reflection form of a wavelength conversion film with air gaps according to another embodiment of the present disclosure;
FIGS. 12 to 14 are schematic cross-sectional views of a lighting device to which a wavelength conversion film according to another embodiment of the present disclosure is applied;
FIG. 15 is a cross-sectional view of a wavelength conversion film according to another embodiment of the present disclosure; and
FIG. 16 is a cross-sectional view of a wavelength conversion film according to another embodiment of the present disclosure.

### DETAILED DESCRIPTION OF THE EMBODIMENTS

Hereinafter, embodiments of the present disclosure will be described in detail with reference to the accompanying drawings so that those skilled in the art may easily implement the present disclosure. However, it should be understood that it is not intended to limit the invention to the specific embodiments, but it includes all changes, equivalents, and substitutes included in the spirit and scope of the present disclosure.

When a component is referred to as being "coupled" or "connected" to another component, it should be understood that it may be directly coupled to or connected to another component, but other components may exist in the middle.

On the other hand, when a component is referred to as being "directly coupled" or "directly connected" to another component, it should be understood that there are no other components in the middle.

Terms used herein are only used to describe specific embodiments, and are not intended to limit the present disclosure. Unless the context clearly means otherwise, the singular expression includes plural expression. It should be understood that, herein, the terms "comprises" or "have," etc. are intended to specify that there is a stated feature, number, process, operation, component, part, or a combination thereof herein, and it does not exclude in advance the possibility of presence or addition of one or more other features, numbers, processes, operations, components, parts, or combinations thereof.

Unless otherwise defined, all terms used herein, including technical and scientific terms, have the same meaning as commonly understood by those of ordinary skill in the art to which the present disclosure belongs. Terms as defined in a commonly used dictionary should be interpreted as having a meaning consistent with the meaning of the related technology, and they are not to be construed in an ideal or excessively formal sense unless explicitly defined in the present application.

The term MODULE described herein means a unit that processes a specific function or operation, and may mean hardware or software, or a combination of hardware and software.

Terms or words used in the specification and claims should not be construed as being limited to their conventional or dictionary meanings. They should be interpreted as meanings and concepts consistent with the technical idea of the present disclosure, based on the principle that the inventor may appropriately define the concept of terms in order to describe his own invention in the best way. In addition, unless there are other definitions of technical and scientific terms used, they have the meanings commonly understood by those of ordinary skill in the art to which this invention belongs. In the following description and the accompanying drawings, descriptions of known functions and configurations that may unnecessarily obscure the subject matter of the present disclosure will be omitted. The drawings introduced below are provided as examples in order to sufficiently convey the spirit of the present disclosure to those skilled in the art. Accordingly, the present disclosure is not limited to the drawings presented below and may be embodied in other forms. In addition, the same reference numerals throughout the specification indicate the same components. It should be noted that the same components in the drawings are indicated by the same reference numerals wherever possible.

Prior to the detailed description of the present disclosure, the principle of converting and outputting a specific wavelength using quantum dots among wavelength conversion materials will be described as follows.

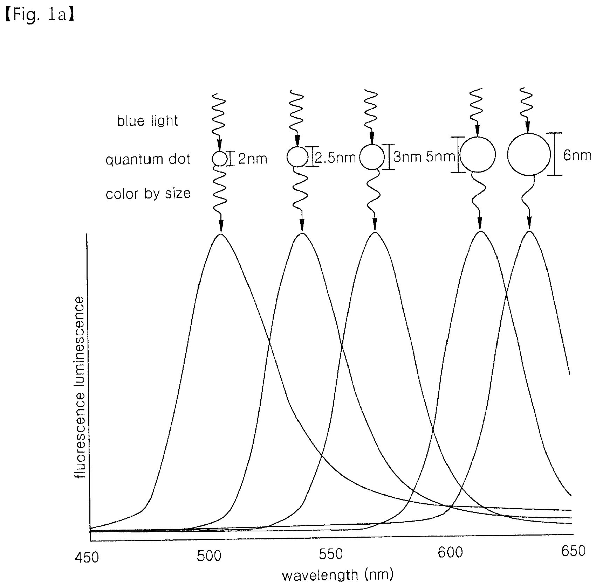

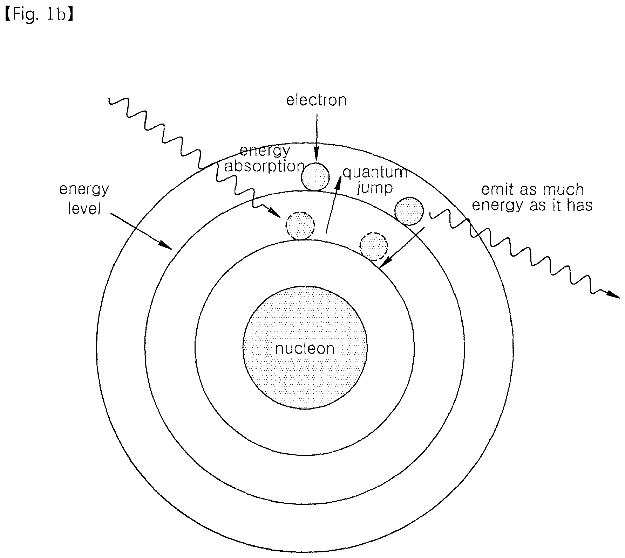

FIGS. 1A and 1B are conceptual views for explaining the principle of quantum dots, respectively.

The quantum dot refers to a semiconductor crystal synthesized by a nanometer (nm) unit. When the quantum dot is irradiated with ultraviolet light (blue light), even particles of the same component emit various colors depending on a size of a particle. These properties are better represented by semiconductor materials than by ordinary materials. In a quantum dot semiconductor crystal, elements such as cadmium, cadmium sulfide, cadmium selenide, and indium phosphide having such characteristics are used. Recently, indium phosphide cores are covered with a zinc-selenium-sulfur alloy (ZnSeS) to remove cadmium, a heavy metal.

As shown in FIG. 1A, when a particle size of the quantum dot is small, it emits visible light with a short wavelength such as green. As its size increases, it emits visible light with a longer wavelength like red. In general, it has a characteristic of emitting energy of various wavelengths by adjusting a band gap energy according to the size of the quantum dot by the quantum confinement effect. In other words, as an energy level of electrons decreases inside the quantum dot, light is emitted. The larger the size of the quantum dot, the narrower the energy levels are. Therefore, long wavelength red color with relatively low energy is emitted.

Here, the quantum confinement effect is a phenomenon in which electrons form a discontinuous energy state by a space wall when a particle is less than several tens of nanometers, and as a size of the space decreases, the energy state of the electrons increases and has a wide band energy.

Referring to FIG. 1B, the principle of quantum dot is that when electrons, in particular, in a semiconductor material in which quantums are united receive energy such as ultraviolet rays, they rise to a higher energy level by quantum jump, then it releases energy again and repeats that it drops to a lower energy level. This energy emits energy of various wavelengths depending on the size of the quantum dot. If the wavelength (energy) is in the visible light band (380nm ∼ 800nm), it emits various visible colors as wavelengths in the form of energy.

In other words, when the quantum dot absorbs light from an excitation source and reaches an energy excited state, it emits energy corresponding to an energy band gap of the quantum dot. Therefore, by controlling the size or material composition of the quantum dot, it is possible to adjust the energy band gap, so that luminescence in all areas from the ultraviolet region to the infrared region is possible.

As a method of manufacturing a quantum dot, a vapor deposition method such as metal organic chemical vapor deposition (MOCVD) or molecular beam epitaxy (MBE) may be used, or a wet chemical synthesis method may be used. Quantum dots manufactured by the wet chemical synthesis method are dispersed in a solvent in a colloidal state. Therefore, the quantum dots are separated from the solvent through centrifugation, and the separated quantum dots may be dispersed in a prepared metal-organic precursor solution. Here, the quantum dot may be stabilized by bonding of a metal-organic precursor to an organic material.

When these quantum dots are applied by dividing an area on a transparent material film by type, and artificial light such as LED is incident, only light of a specific wavelength preset by a user for each characteristic of the quantum dot is output. Naturally, a third wavelength may be set by mixing and distributing at least two or more kinds of quantum dots in a certain coating region of a film.

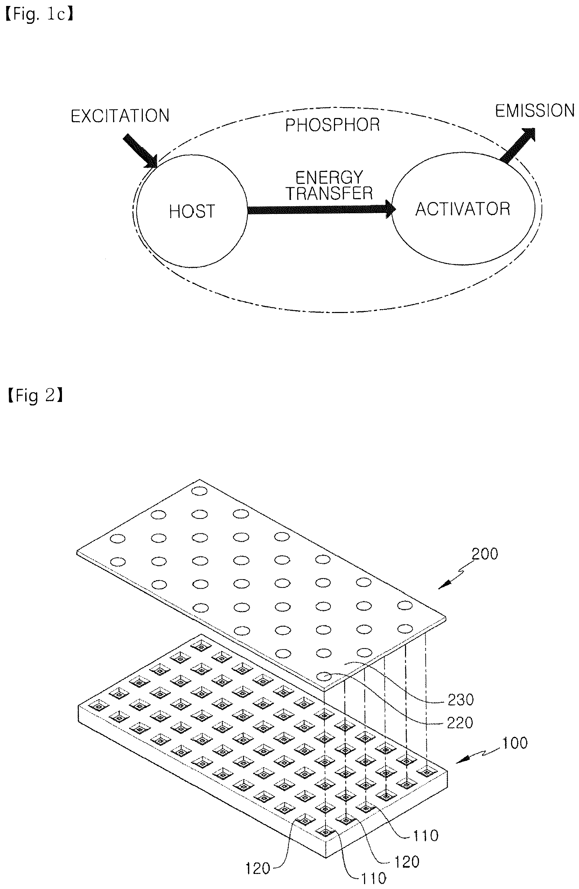

Next, a principle of selectively sensing a specific wavelength or selectively outputting a specific wavelength using an inorganic phosphor will be described. FIG. 1C is a view showing a luminescence principle of a phosphor.

When a certain type of energy is incident inside a particle, visible light is produced by a certain action within the particle. This process is called luminescence. For the luminescence principle of phosphor, when a phosphor receives energy, free electrons and holes are formed, and it changes into a high-level energy state. As it returns to its stable state, its energy is emitted as visible light. The phosphor is composed of a host material and an activator in which impurities are mixed at an appropriate position. Active ions determine a luminescence color of the phosphor by determining an energy level involved in a luminescence process.

Therefore, it uses the principle that phosphors containing active ions that emit light of a specific wavelength are applied or colored by dividing an area on a transparent material film for each type, and then when artificial light such as LED is incident, only light of a specific wavelength preset by a user for each characteristic of the phosphor is output. Naturally, a third wavelength may be set in a manner in which at least two or more types of phosphors are mixed and coated on a certain coating area of a film.

FIG. 2 is a schematic exploded perspective view of a lighting device according to an embodiment of the present disclosure.

Referring to the accompanying FIG. 2, the lighting device according to the embodiment of the present disclosure largely includes a lighting unit 100 and a wavelength conversion film 200.

The lighting unit 100 emits light according to the application of electric energy, and includes a first light source in a first wavelength band and a second light source in a second wavelength band. In addition, although not shown in the drawing, the lighting unit 100 may further include an inverter that converts the first light source 110 and the second light source 120 into power suitable for driving, a control module that controls on/off of the power, or the like. Here, the light source is defined as an optical emitter configured to generate and emit light. For example, the light source may include an optical emitter, such as a light emitting diode (LED), that emits light when activated or turned on. In particular, The light source defined in the present disclosure may be substantially any light source, and may include substantially any optical emitter including one or more of a light emitting diode (LED), a laser, an organic light emitting diode (OLED), a polymer light emitting diode, a plasma-based optical emitter, a fluorescent lamp, an incandescent lamp, and virtually any other light source. Light produced by the light source may have a color (color) (i.e., may contain a specific wavelength of light), or may be a range of wavelengths (e.g., white light). In some embodiments, the light source may include a plurality of various optical emitters. Further, the light source may comprise a set or group, and generates light having a color or wavelength different from or equal to a color of light generated by at least one other light source in the set or group. Different colors may include, for example, a primary color (e.g., red, green, blue).

The first light source 110 and the second light source 120 may be composed of one or more combinations selected from various colors including red, orange, yellow, yellow green, pure green, and blue, and may be arranged in various patterns. Here, the first light source 110 is a first color, and the second light source 120 is composed of a second color different from the first color. For example, when the first light source 110 is blue, the second light source 120 is selected from green and red.

In addition, the first light source 110 and the second light source 120 may be repeatedly arranged in a predetermined pattern. For example, as shown in FIG. 2, the first light source 110 and the second light source 120 are arranged in a grid shape, in which light sources of different colors may be arranged in the front and rear and left and right for one selected light source.

In the wavelength conversion film 200, a wavelength conversion region 220 is arranged at a position opposite to the first light source 110, and a transmission region 230 is arranged at a position opposite to the second light source. The wavelength conversion film 200 may be formed of a flexible substrate that may be rolled or bent and wound on a roller, or a curable substrate having a predetermined bending strength.

In addition, the wavelength conversion film 200 may be installed in contact with or spaced apart from an upper surface of the lighting unit 100.

Here, in the present disclosure, an opposite position refers to all or part of a direction in which light emitted from the first light source 110 and the second light source 120 travels. In other words, the wavelength conversion film 200 may be arranged so that all of the light emitted from the first light source 110 passes through the wavelength conversion region 220, and the wavelength conversion film 200 may be arranged so that a part of light emitted to the first light source 110 passes through the wavelength conversion region 220.

In this regard, when the wavelength conversion film 200 is arranged so that all of the light emitted from the first light source 110 passes through the wavelength conversion region 220, light emitted from the first light source 110 is subjected to wavelength conversion in the wavelength conversion region 220. Further, when the wavelength conversion film 200 is arranged so that a part of light emitted from the first light source 110 passes through the wavelength conversion region 220, some light emitted from the first light source 110 is wavelength-converted in the wavelength conversion region 220, but the rest of the light passes through without wavelength conversion.

In other words, the amount of wavelength-converted light may be adjusted according to an arrangement position of the wavelength conversion film 200 arranged opposite to the first light source 110.

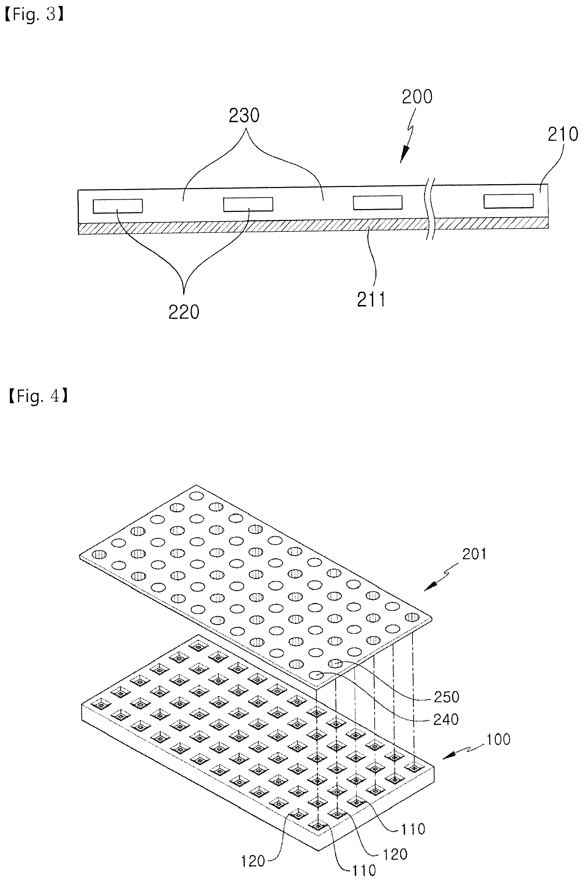

FIG. 3 shows a cross-sectional view of the wavelength conversion film of the embodiment applied to the lighting device according to the present disclosure.

Referring to the accompanying FIG. 3, the wavelength conversion film 200 may include a wavelength conversion region 220 and a barrier film 210 made of a polyester (PET) material coated on an upper and lower portions of the wavelength conversion region 220. In addition, one side of the barrier film 210 may be formed by coating one more time with a composite material 211 that provides a supportive force, thereby securing durability of the wavelength conversion film 200.

Here, the composite material 211 may be a film-type substrate having excellent transparency and heat resistance. The film-type substrate may be selected from polyesters such as poly(meth)acrylate, polyethylene terephthalate (PET), polybutylene terephthalate (PBT), polyethylene naphthalate (PEN), and polyarylate; resins such as polycarbonate, polyvinyl chloride, polyethylene, polypropylene, polystyrene, aliphatic or aromatic polyamide (e.g., nylon, aramid, etc.), polyetheretherketone, polysulfone, polyethersulfone, polyimide, polyamideimide, polyetherimide, cyclic olefin polymer (COP), polyvinylidene chloride.

In the configuration, the wavelength conversion film 200 includes a wavelength conversion region 220 for converting and emitting a wavelength of an incident light source and a transmission region 230 for transmitting an incident light source without wavelength conversion

First, the transmission region 230 transmits wavelength of a light emitted from the second light source 120 without wavelength conversion. For example, when the second light source 120 is red, the light emitted from the second light source 120 is irradiated through the transmission region 230, or is transmitted while maintaining a red wavelength without wavelength conversion.

Next, the wavelength conversion region 220 will be described.

The wavelength conversion region 220 performs a function of converting and emitting wavelength of an incident light source, and includes a wavelength conversion material of any one of inorganic phosphors, quantum dots, perovskites, and cellophanes.

The inorganic phosphor may be any one selected from a group consisting of an oxide-based phosphor, a garnet-based phosphor, a silicate-based phosphor, a sulfide-based phosphor, an oxynitride-based phosphor, a nitride-based phosphor, and a mixture thereof.

The quantum dot may be, for example, II-VI or III-V group, and representative examples thereof may be any one selected from a group consisting of CdS, CdSe, CdTe, ZnS, ZnSe, ZnTe, HgS, HgSe, HgTe, GaN, GaP, GaAs, GaSb, AlN, AlP, AlAs, AlSb, InN, InP, InAs, InSb, Si, Ge, and a mixture thereof.

The perovskite is also referred to as organometallic halide, organometallic halide perovskite compound, or organometallic halide. Among materials having a perovskite structure, the organometallic halide is composed of an organic cation (A), a metal cation (M), and a halogen anion (X), and has a chemical formula of AMX₃.

The cellophane is a material prepared by coagulating a viscose solution obtained by treating cellulose (fiber) with alkali and carbon disulfide in an aqueous sulfuric acid solution.

Depending on design conditions, a light scattering agent may be further mixed with the wavelength conversion material.

The light scattering agent may be selected from polyacrylate-based polymers such as PMMA and PS, silicone-based polymers such as PMSQ, and inorganic dispersants such as SiO₂, TiO₂, and Al₂O₃. Here, the light scattering agent has a wider range of scattering angles as a particle size decreases, in which a degree of scattering varies depending on wavelength of light and a size of a particle. In other words, the scattering range may be adjusted by controlling the size of the scattering particles of the light scattering agent according to the wavelength of light.

The wavelength incident on the wavelength conversion region 220 is emitted to light sources having various wavelengths by adjusting a band gap energy according to a particle size of a wavelength conversion material. In other words, when the particle size of the wavelength conversion material constituting the wavelength conversion region 220 is adjusted, the wavelength of the light emitted through the wavelength conversion region 220 may be adjusted.

For example, when the particle size of the wavelength conversion material in the wavelength conversion region 220 is 2 to 6 nm and the first light source 110 is blue in a state where each particle is uniformly distributed, a blue light irradiated from the first light source 110 passes through the wavelength conversion region 220 and is converted into blue, green, and red wavelengths to be emitted.

According to the wavelength conversion region 220 as described above, in the lighting unit in which light sources of different wavelength bands are mixed, the wavelength of light emitted from a specific lighting unit may be converted and irradiated, and the unselected light may be emitted through the transmission region 230 without wavelength conversion. Therefore, the selection of the emitted light wavelength may be expanded.

Also, even if a blue light source that is relatively inexpensive than a red light source is configured, a blue light source may be converted into a light source having red and green wavelengths for irradiation. Therefore, it is possible to reduce the manufacturing cost of a lighting device.

In addition, the entire wavelength conversion film is not coated or colored with a wavelength conversion material, and only a selected part is applied or colored with a wavelength conversion material. Therefore, only the wavelength of light emitted from the selected specific light source may be converted and emitted. Accordingly, the input amount of the wavelength conversion material is reduced, thereby reducing the manufacturing cost.

FIG. 4 is a schematic exploded perspective view of a lighting device according to another embodiment of the present disclosure.

Referring to the accompanying FIG. 4, the lighting device according to the another embodiment of the present disclosure includes a lighting unit 100 and a wavelength conversion film 201.

A first light source 110 in a first wavelength band and a second light source 120 in a second wavelength band are arranged in the lighting unit 100.

The first light source 110 and the second light source 120 may be composed of one or more combinations selected from various colors including red, orange, yellow, yellow green, pure green, and blue, and may be arranged in various patterns. Here, the first light source 110 is a first color, and the second light source 120 is composed of a second color different from the first color. For example, when the first light source 110 is blue, the second light source 120 is selected from green and red.

The second light source 120 is composed of a second color different from that of the first light source 110. In addition, the first light source 110 and the second light source 120 may be repeatedly arranged in a predetermined pattern.

In the wavelength conversion film 201, a first wavelength conversion region 240 is arranged at a position opposite to the first light source 110, and a second wavelength conversion region 250 is arranged at a position opposite to the second light source 120.

In addition, the wavelength conversion film 201 converts wavelength of a light emitted from the first light source 110 and wavelength of a light emitted from the second light source 120 to emit them.

The wavelength conversion film 201 may be formed of a flexible substrate that may be rolled or bent and wound on a roller, or a curable substrate having a predetermined bending strength. In addition, the first wavelength conversion region 240 and the second wavelength conversion region 250 perform a function of converting and emitting wavelength of an incident light source, and include a wavelength conversion material of any one of inorganic phosphors, quantum dots, perovskites, and cellophanes.

According to the configuration described above, the wavelength conversion film 201 may convert wavelength of a light emitted from the first light source 110 and wavelength of a light emitted from the second light source 120 to emit them. Therefore, the entire wavelength of light emitted from the lighting unit 100 may be converted and emitted. Naturally, the first wavelength conversion region 240 and the second wavelength conversion region 250 are applied or colored while being limited to opposite positions of the first light source 110 and the second light source 120, respectively.

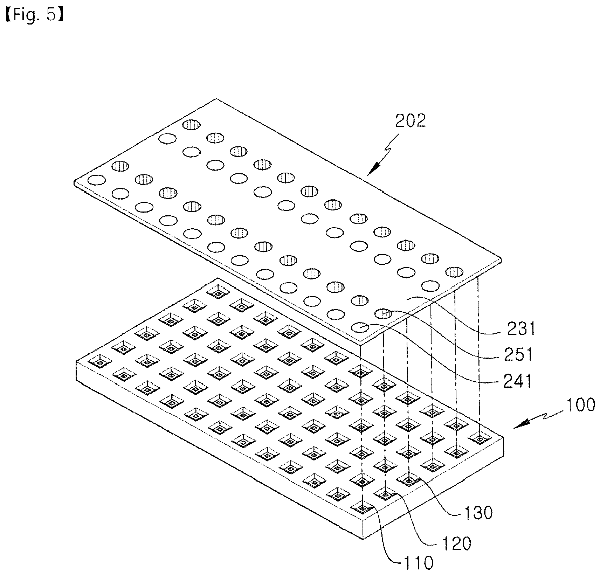

FIG. 5 is a schematic exploded perspective view of a lighting device according to another embodiment of the present disclosure.

Referring to the accompanying FIG. 5, a first light source 110 in a first wavelength band, a second light source 120 in a second wavelength band, and a third light source 130 in a third wavelength band are arranged in a lighting unit 100. In a wavelength conversion film 202, a first wavelength conversion region 241 is arranged at a position opposite to the first light source 110, a second wavelength conversion region 251 is arranged at a position opposite to the second light source 120, and a transmission region 231 is arranged at a position opposite the third light source 130.

The first light source 110, the second light source 120, and the third light source 130 may be composed of one or more combinations selected from various colors including red, orange, yellow, yellow green, pure green, and blue, and may be arranged in various patterns. Here, the first light source 110 is a first color, the second light source 120 is a second color different from the first color, and the third light source 130 is composed of a third color different from the first color of the first light source and the second color of the second light source.

The first wavelength conversion region 241 and the second wavelength conversion region 251 perform a function of converting and emitting wavelength of an incident light source, respectively, and include a wavelength conversion material of any one of inorganic phosphors, quantum dots, perovskites, and cellophanes.

The transmission region 231 transmits wavelength of light emitted from the third light source 130 without wavelength conversion.

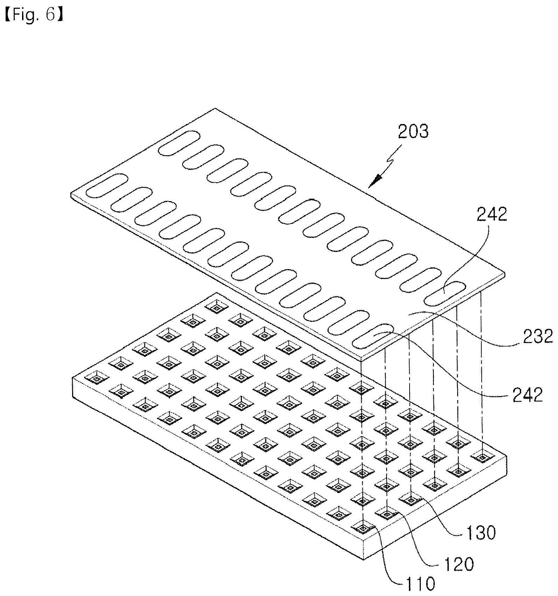

FIG. 6 shows a schematic exploded perspective view of a lighting device according to another embodiment of the present disclosure.

Referring to the accompanying FIG. 6, a first light source 110 in a first wavelength band, a second light source 120 in a second wavelength band, and a third light source 130 in a third wavelength band are arranged in a lighting unit 100. In a wavelength conversion film 203, a first wavelength conversion region 242 is arranged at a position opposite to the first light source 110 and the second light source 120, and a transmission region 232 is arranged at a position opposite to the third light source 130.

The first wavelength conversion region 242 performs a function of converting and emitting wavelength of light source incident from the first light source 110 and the second light source 120, and includes a wavelength conversion material of any one of inorganic phosphors, quantum dots, perovskites, and cellophanes.

The transmission region 232 transmits wavelength of light source from the third light source 130 without wavelength conversion.

Referring to FIGS. 5 and 6, the wavelength conversion region and the transmission region of the wavelength conversion film may be formed in various patterns depending on the arrangement of the light source, the emitted color, or the light source requiring wavelength conversion. In addition, depending on design conditions, combinations or patterns of the wavelength conversion region and the transmission region not described through the embodiments of the present disclosure may be variously changed. Naturally, the combinations or patterns not described in the embodiments of the present disclosure also belong to the scope of the present disclosure.

Next, a wavelength conversion film according to the present disclosure will be described through various embodiments.

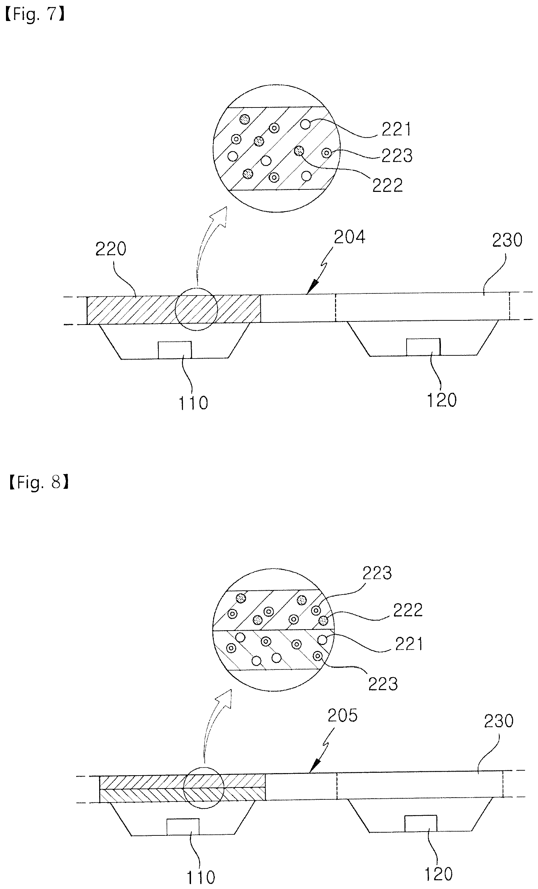

FIGS. 7 and 8 are schematic cross-sectional views of a lighting device to which a wavelength conversion film according to an embodiment of the present disclosure is applied, respectively.

Referring to the accompanying FIG. 7, in a wavelength conversion film 204, a wavelength conversion region 220 is arranged at a position opposite to a first light source 110 in a first wavelength band, and a transmission region 230 is arranged at a position opposite to a second light source 120 in a second wavelength band. In addition, although not shown in the drawing, it may further include a barrier film coated with the wavelength conversion region 220 and a composite material coated on one side of the barrier film.

In the configuration described above, the first light source 110 and the second light source 120 of the lighting unit may be composed of one or more combinations selected from various colors including red, orange, yellow, yellow green, pure green, and blue, and may be arranged in various patterns. Here, the first light source 110 is a first color, and the second light source 120 is composed of a second color different from the first color.

The wavelength conversion region 220 of the wavelength conversion film 204 may include any one wavelength conversion material of inorganic phosphors, quantum dots, perovskites, and cellophanes.

Alternatively, the wavelength conversion region 220 may include a mixed layer of at least two of inorganic phosphors, quantum dots, perovskites, and light scattering agents.

In addition, the wavelength conversion region 220 may include one material selected from inorganic phosphors, quantum dots, and perovskites, or may further include a light scattering agent in one material selected from the materials (inorganic phosphor, quantum dot, and perovskite).

In addition, as shown in FIG. 7, the wavelength conversion region 220 may be formed of a mixed layer including and mixing one first wavelength conversion material 221 selected from inorganic phosphors, quantum dots, and perovskites, a second wavelength conversion material 222 different from the first wavelength conversion material 221, and a light scattering agent 223.

In addition, the wavelength conversion region 220 may be configured in a form in which a first wavelength conversion material layer including the one first wavelength conversion material 221 selected from inorganic phosphors, quantum dots, and perovskites and a second wavelength conversion material layer including the second wavelength conversion material 222 different from the first wavelength conversion material 221 are stacked.

In addition, as shown in FIG. 8, the wavelength conversion region 220 of the wavelength conversion film 205 may be configured in a form in which a third wavelength conversion material layer including and mixing the light scattering agent in the one first wavelength conversion material 221 selected from inorganic phosphors, quantum dots, and perovskites, and a fourth wavelength conversion material layer including and mixing the light scattering agent 223 in the second wavelength conversion material 222 different from the first wavelength conversion material 221 are stacked.

Here, a particle size of the first wavelength conversion material 221 and a particle size of the second wavelength conversion material 222 may be configured differently. Even in the case of the same wavelength conversion material, it may be configured to induce various wavelength conversion by varying the particle size.

As such, the light emitted from the first light source 110 is incident on the wavelength conversion region 220, and the wavelength of light incident on the wavelength conversion region 220 is converted and emitted by the wavelength conversion material constituting the wavelength conversion region 220. In addition, the light emitted from the second light source 120 is emitted without wavelength conversion through the transmission region 230.

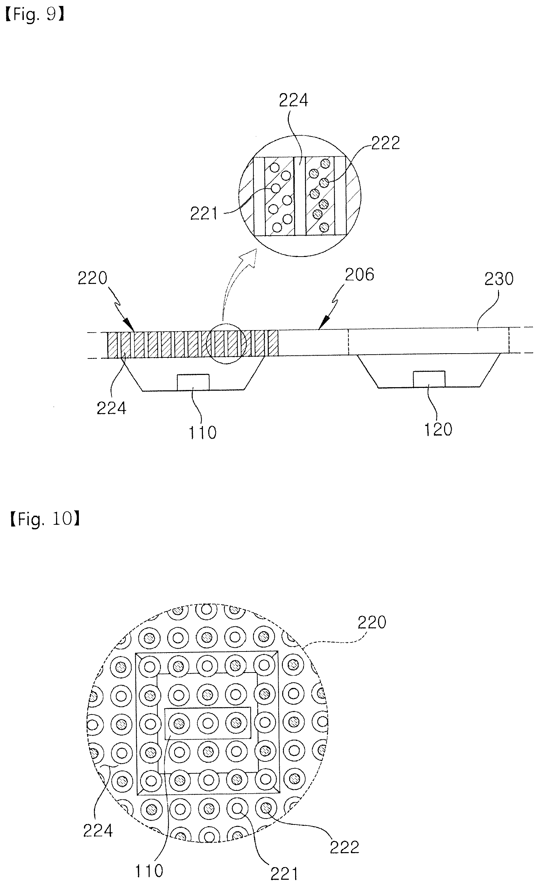

FIGS. 9 and 10 show schematic cross-sectional and plan views, respectively, of a lighting device to which a wavelength conversion film according to another embodiment of the present disclosure is applied.

Referring to FIGS. 9 and 10, in the wavelength conversion region 220 of the wavelength conversion film 206, an air gap 224 is formed between the wavelength conversion materials. Here, the wavelength conversion material has a structure in which a columnar shape is arranged in a grid shape. Naturally, the columnar-shaped wavelength conversion material may be changed into various shapes such as a triangular column, a square column, a pentagonal column, and an elliptical column according to design conditions.

The wavelength conversion material may be composed of any one of inorganic phosphors, quantum dots, perovskites, and cellophanes, and may be composed of a mixture of at least two of the wavelength conversion materials. In addition, the wavelength conversion material may be composed of a mixture of at least two of inorganic phosphors, quantum dots, perovskites, and light scattering agents.

The air gap 224 functions as a space between the wavelength conversion materials and changes a dielectric constant, and partially reflects wavelength of light converted in the wavelength conversion material to increase the time to stay in the wavelength conversion material.

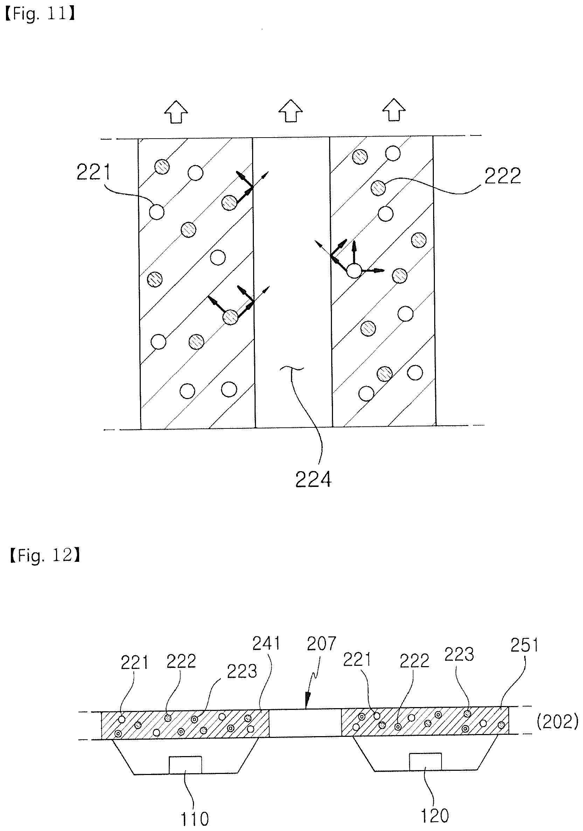

FIG. 11 is a view showing a light reflection form of a wavelength conversion film with air gaps according to another embodiment of the present disclosure.

Referring to the accompanying FIG. 11, wavelength of light incident on the wavelength conversion region is converted and emitted according to a particle size of the wavelength conversion material. Here, a dielectric constant of the air gap 224 and a dielectric constant of the wavelength conversion material are different. Accordingly, when the light changed and emitted inside the wavelength conversion material collides an interface between the air gap 224 and the wavelength conversion material, the collided light is reflected according to the change in dielectric constant at the interface and reflected into the wavelength conversion material, and the remaining part passes through the interface and enters the air gap 224.

Here, the amount of light reflected from the interface is relatively larger than the amount of light passing through the interface. Therefore, light reflected into the wavelength conversion material increases the time remaining in the wavelength conversion material, resulting in an increase in the conversion rate of the light wavelength.

In addition, most of the light wavelengths incident on the air gap 224 are also reflected at the interface and emitted without wavelength conversion, but the remaining part passes through the interface and enters the wavelength conversion material.

As such, the air gap 224 serves to emit light wavelengths without wavelength conversion, and at the same time, serves to increase the conversion efficiency of the light wavelength incident on the wavelength conversion material by forming the interface according to the change in dielectric constant.

FIGS. 12 to 14 show schematic cross-sectional views of a lighting device to which a wavelength conversion film according to another embodiment of the present disclosure is applied.

First, referring to the accompanying FIG. 12, a wavelength conversion film 207 includes a first wavelength conversion region 241 arranged at a position opposite to a first light source 110 in a first wavelength band of a lighting unit, and a second wavelength conversion region 251 arranged at a position opposite to a second light source 120 in a second wavelength band of the lighting unit.

The first light source 110 and the second light source 120 may be composed of one or more combinations selected from various colors including red, orange, yellow, yellow green, pure green, and blue, and may be arranged in various patterns. Here, the first light source 110 is a first color, and the second light source 120 is composed of a second color different from the first color.

The first wavelength conversion region 241 and the second wavelength conversion region 251 may include any one wavelength conversion material of inorganic phosphors, quantum dots, perovskites, and cellophanes.

Alternatively, the first wavelength conversion region 241 and the second wavelength conversion region 251 may include a mixed layer of at least two of inorganic phosphors, quantum dots, perovskites, and light scattering agents.

In other words, as shown in the accompanying FIG. 12, the first wavelength conversion region 241 and the second wavelength conversion region 251 may be formed of a mixed layer including and mixing one first wavelength conversion material 221 selected from inorganic phosphors, quantum dots, and perovskites, a second wavelength conversion material 222 different from the first wavelength conversion material 221, and a light scattering agent 223.

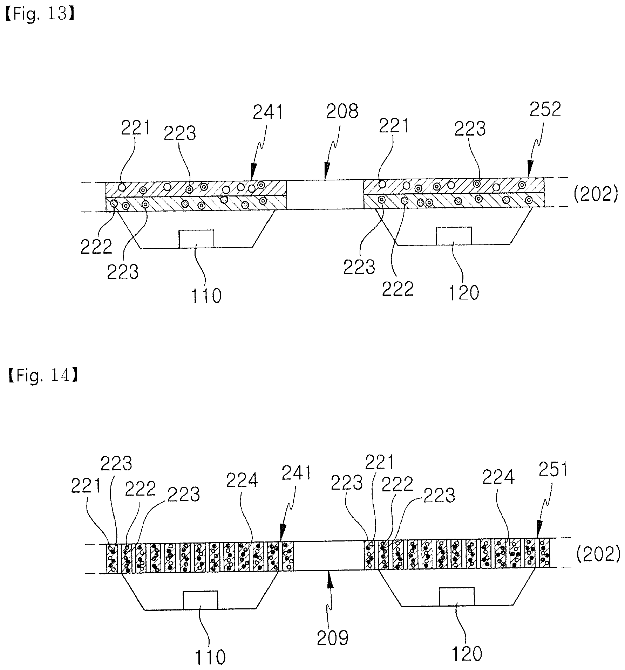

In addition, as shown in the accompanying FIG. 13, the first wavelength conversion region 241 and the second wavelength conversion region 251 may be configured in a form in which a first wavelength conversion material layer including the one first wavelength conversion material 221 selected from inorganic phosphors, quantum dots, and perovskites and a second wavelength conversion material layer including the second wavelength conversion material 222 different from the first wavelength conversion material 221 are stacked. Moreover, the light scattering agent 223 may be further mixed with the first wavelength conversion material layer and the second wavelength conversion material layer.

Here, a particle size of the first wavelength conversion material 221 and a particle size of the second wavelength conversion material 222 may be configured differently. Even when the same wavelength conversion material is used, a layer may be formed by varying the particle size.

In addition, as shown in the accompanying FIG. 14, in the first wavelength conversion region 241 and the second wavelength conversion region 251 of the wavelength conversion film 209, an air gap 224 may be formed between the wavelength conversion materials.

The air gap 224 functions as a space between the wavelength conversion materials and changes a dielectric constant, and changes a dielectric constant to partially reflect light wavelength converted in the wavelength conversion material, thereby increasing the time to stay in the wavelength conversion material.

The wavelength converted in the wavelength conversion region may be scattered as necessary to expand an irradiation range, or may be guided in a predetermined direction so as to be concentrated and irradiated in a specific area.

Here, scattering of the emitted light is also possible with a light scattering agent. However, the scattering effect may be further enhanced by forming a fine pattern on a surface of the wavelength conversion film.

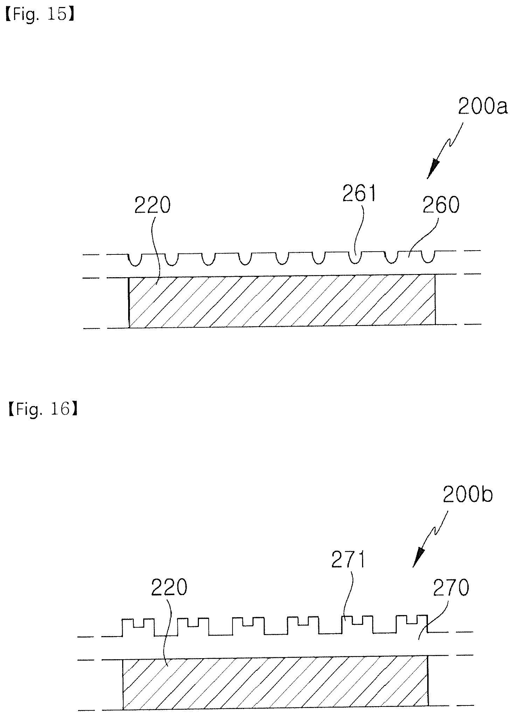

FIG. 15 is a cross-sectional view of a wavelength conversion film according to another embodiment of the present disclosure, and is for scattering emitted light.

Referring to the accompanying FIG. 15, a first nano patterned layer 260 for scattering emitted light is formed on a surface of a wavelength conversion film 200a according to another embodiment of the present disclosure.

The first fine pattern layer 260 has a recess 261 recessed downwardly in a predetermined pattern. Depending on design conditions, the recess 261 may be replaced with a convex protruding upward.

Accordingly, the recess 261 of the first fine pattern layer 260 may scatters the emitted light, and the light may be dispersed in a relatively wider range.

FIG. 16 is a cross-sectional view of a wavelength conversion film according to another embodiment of the present disclosure, and is for inducing emitted light into a predetermined direction.

Referring to the accompanying FIG. 16, a second nano patterned layer 270 for inducing emitted light is formed on a surface of a wavelength conversion film 200b according to another embodiment of the present disclosure.

The second fine pattern layer 270 has a protrusion 271 protruding upwardly in a predetermined pattern. Depending on design conditions, the protrusion 271 may be replaced with a dent recessed downward.

As it may be seen above, the wavelength conversion film and the lighting device using the same according to the present disclosure are configured to transmit light that does not require excitation, and transmit light that requires excitation through a patterned wavelength conversion material. Therefore, it is possible to expand the selection of the emitted light wavelength.

In addition, according to the wavelength conversion film in accordance with the present disclosure, it is possible to irradiate by converting the wavelength of light simply by attaching it to an already manufactured lighting unit. Even if a blue light source which is relatively cheaper than a red light source is configured, the blue light source may be converted into light of red and green wavelengths and irradiated. Therefore, it is possible to lower the manufacturing cost of the lighting device.

Moreover, when the wavelength conversion film and the lighting device using the same according to the present disclosure are applied to plant growth, the wavelength conversion required for plant growth is easy, and a light source suitable for plant growth may be provided so that plants may be grown early. Therefore, it is possible to increase production efficiency while shortening a growth cycle of plant growth.

A preferred embodiment of the wavelength conversion film and the lighting device using the same according to the present disclosure has been described above. However, the present disclosure is not limited thereto. It is possible to implement various modifications within the scope of the claims and the description of the invention and the accompanying drawings. This also falls within the scope of the present disclosure.

**[Reference Numeral]**

| | |
|---|---|
| 100: lighting unit | 110: first light source |
| 120: second light source | 130: third light source |
| 200, 201, 202, 203, 204, 205, 206, 207, 208, 209, 200a, 200b: | wavelength conversion film |
| 210: barrier film | 211: composite material |
| 220: wavelength conversion region | |
| 221: first wavelength conversion material | |
| 222: second wavelength conversion material | 223: light scattering agent |
| 224: air gap | |
| 230, 231, 232: transmission region | |
| 240, 241, 242: first wavelength conversion region | |
| 250, 251: second wavelength conversion region | |
| 260: first fine pattern layer | 261: recess |
| 270: second fine pattern layer | 271: protrusion |

### [Bibliography]

- Project Number: S2799140
- Project Unique Number: 1425136755
- Organization Name: Ministry of SMEs and Startups
- Specialized Institution for Research Management: Korea Technology and information Promotion Agency for SMEs
- Research Business Name: Startup Growth - Technology Development Business
- Research Project Name: Development of optical editing solution for producing low energy/high productivity medical cannabis
- Management Organization: Sherpa Space Inc.
- Research Period: November 25, 2019 ∼ November 24, 2021

## Claims

1. A lighting device, comprising:
a lighting unit in which a first light source in a first wavelength band and a second light source in a second wavelength band are arranged; and
a wavelength conversion film in which a wavelength conversion region is arranged at a position opposite to the first light source, and a transmission region is arranged at a position opposite to the second light source.

2. The device of claim 1, wherein the first light source is a first color, and the second light source is a second color different from the first color.

3. The device of claim 1 or 2, wherein the first light source and the second light source are repeatedly arranged in a predetermined pattern.

4. The device of any of the preceding claims, wherein the wavelength conversion region comprises any one wavelength conversion material of inorganic phosphors, quantum dots, perovskites, and cellophanes.

5. A lighting device, comprising:
a lighting unit in which a first light source in a first wavelength band and a second light source in a second wavelength band are arranged; and
a wavelength conversion film in which a first wavelength conversion region is arranged at a position opposite to the first light source, and a second wavelength conversion region is arranged at a position opposite to the second light source.

6. The device of claim 5, wherein the first light source is a first color, and the second light source is a second color different from the first color.

7. The device of claim 5 or 6, wherein the first light source and the second light source are repeatedly arranged in a predetermined pattern.

8. The device of any of claims 5 to 7, wherein the first wavelength conversion region and the second wavelength conversion region comprise any one wavelength conversion material of inorganic phosphors, quantum dots, perovskites, and cellophanes.

9. A wavelength conversion film, wherein a wavelength conversion region is arranged at a position opposite to a first light source in a first wavelength band of a lighting unit,
wherein a transmission region is arranged at a position opposite to a second light source in a second wavelength band of the lighting unit.

10. The film of claim 9,
wherein the first light source is a first color, and the second light source is a second color different from the first color,
and/or
wherein the wavelength conversion region comprises any one wavelength conversion material of inorganic phosphors, quantum dots, perovskites, and cellophanes.

11. The film of claim 9 or 10,
wherein the wavelength conversion region comprises a mixed layer of at least two of inorganic phosphors, quantum dots, perovskites, and light scattering agents,
and/or
wherein at least two of an inorganic phosphor layer, a quantum dot layer, and a perovskite layer are stacked in the wavelength conversion region.

12. The film of any of claims 9 to 11, wherein an air gap is formed between the wavelength conversion materials in the wavelength conversion region.

13. The film of claim any of claims 9 to 12,
wherein a first nano patterned layer for scattering emitted light is formed on a surface of the wavelength conversion film,
and/or
wherein a second nano patterned layer for inducing emitted light in a preset direction is formed on a surface of the wavelength conversion film.

14. A wavelength conversion film, wherein a first wavelength conversion region is arranged in a region opposite to a first light source in a first wavelength band of a lighting unit, and
wherein a second wavelength conversion region is arranged in a region opposite to a second light source in a second wavelength band of the lighting unit.

15. The film of claim 14,
wherein the first light source is a first color, and the second light source is a second color different from the first color,
and/or
wherein the wavelength conversion region comprises any one wavelength conversion material of inorganic phosphors, quantum dots, perovskites, and cellophanes,
and/or
wherein an air gap is formed between the wavelength conversion materials in the first wavelength conversion region and the second wavelength conversion region.
